# EUROPEAN PATENT APPLICATION

(11) **EP 4 756 465 A1**
(43) Date of publication of application: **10.06.2026**
(21) Application number: 23947377.0
(22) Date of filing: 30.11.2023
(51) Int. Cl.: G01R 33/02

(54) **MULTI-AXIS MAGNETIC FIELD SENSOR**

(30) Priority: 01.08.2023 CN 202310960517
(71) Applicant: MultiDimension Technology Co., Ltd., Jiangsu 215634 (CN)
(72) Inventor: LIU, Mingfeng, Jiangsu 215634 (CN); SHI, Ran, Jiangsu 215634 (CN); XUE, Songsheng, Jiangsu 215634 (CN)
(74) Representative: HGF
(86) International application number: PCT/CN2023/135281
(87) International publication number: WO 2025/025439

(57) **Abstract**

A multi-axis magnetic field sensor. The multi-axis magnetic field sensor includes: a first magnetic conductor (1D) in a first direction, a second magnetic conductor (2D) located in the same plane as the first magnetic conductor (1D), a first magnetic induction unit (2Ya), and second magnetic induction units (2X, 2Xa, 2Xb, 2Xc, 2Xd). The first magnetic conductor (1D) has a first air gap in a second direction. The second magnetic conductor (2D) includes: magnetic field input regions (1A, 1B, 1Ax, 1Bx, 1Axa, 1Axb, 1Bxa, 1Bxb) located in the second direction and at two ends of the second magnetic conductor (2D) and magnetic field conversion regions (1Ca, 1Cb, 1Cc, 1Cd, 1Ce, 1Cf, 1Cg, 1Ch, 1Ea, 1Eb, 1Ec, 1Ed, 1Ee, 1Ef) located between the two ends of the second magnetic conductor (2D), in which the magnetic field conversion regions (1Ca, 1Cb, 1Cc, 1Cd, 1Ce, 1Cf, 1Cg, 1Ch, 1Ea, 1Eb, 1Ec, 1Ed, 1Ee, 1Ef) include a conversion magnetic circuit in the first direction, and the conversion magnetic circuit has a second air gap in the second direction. The projection of the first magnetic induction unit (2Ya) on the plane is located in a first air gap region. The projections of the second magnetic induction units (2X, 2Xa, 2Xb, 2Xc, 2Xd) on the plane are located in a second air gap region. The multi-axis magnetic field sensor can measure the magnetic flux intensity in the first direction and the second direction by means of the first magnetic induction unit (2Ya) and the second magnetic induction units (2X, 2Xa, 2Xb, 2Xc, 2Xd) having the same magnetic induction sensitivity direction, without rotating the magnetic induction units.

## Description

### Technical Field

The present application relates to the technical field of magnetic induction, and more specifically, to a multi-axis magnetic field sensor.

### Background of the Invention

A magnetic sensor is a device that converts changes in the magnetic properties of a sensitive element caused by external factors such as magnetic field, current, stress and strain, temperature, and light into electrical signals, thereby detecting corresponding physical quantities. It has been widely used in modem industry and electronic products to measure physical parameters such as current, position, and direction by sensing changes in magnetic field strength.

Most existing multi-axis magnetic field sensors are obtained by means of chip packaging. Specifically, taking a two-axis magnetic compass chip as an example, it is obtained by rotating a magnetic induction unit with the X-axis magnetic sensitivity direction by 90° to obtain a magnetic induction unit with the Y-axis magnetic sensitivity direction, and then packaging the magnetic induction unit with the X-axis magnetic sensitivity direction and the obtained magnetic induction unit with the Y-axis magnetic sensitivity direction together. Existing multi-axis magnetic field sensors are prone to angular deviations during the packaging process and impose high requirements for the packaging process.

### Summary of the Invention

In view of this, the objective of embodiments of the present application is to provide a multi-axis magnetic field sensor to solve the technical problem that existing multi-axis magnetic field sensors are prone to angular deviations during the packaging process and impose high requirements for the packaging process.

Specifically, embodiments of the present application provide a multi-axis magnetic field sensor, comprising a first magnetic conductor in a first direction, the first magnetic conductor having a first air gap in a second direction; wherein the first direction and the second direction are perpendicular to each other;
a second magnetic conductor located in the same plane as the first magnetic conductor, the second magnetic conductor comprising: magnetic field input regions located in the second direction and at two ends of the second magnetic conductor and magnetic field conversion regions located between the two ends of the second magnetic conductor, in which the magnetic field conversion regions comprise a conversion magnetic circuit in the first direction; wherein the conversion magnetic circuit has a second air gap in the second direction;
a first magnetic induction unit, a projection of the first magnetic induction unit on the plane being located in the first air gap region; the sensor forming, based on the first magnetic induction unit, a first magnetic signal output circuit for measuring the magnetic flux intensity in the first direction;
second magnetic induction units, the projections of the second magnetic induction units on the plane being located in the second air gap region; the sensor forming, based on the second magnetic induction units, a second magnetic signal output circuit for measuring the magnetic flux intensity in the second direction;
wherein the first magnetic induction unit and the second magnetic induction units have the same magnetic induction sensitivity direction, which is parallel to the first direction.

In the above-described implementation process, the multi-axis magnetic field sensor comprises the first magnetic conductor in the first direction, the second magnetic conductor located in the same plane as the first magnetic conductor, the first magnetic induction unit, and the second magnetic induction units, and the second magnetic conductor comprises: the magnetic field input regions located in the second direction and at two ends of the second magnetic conductor and magnetic field conversion regions located between the two ends of the second magnetic conductor. A magnetic field to be measured in the second direction input by the magnetic field input regions is converted based on the magnetic field conversion regions, the conversion magnetic circuit in the first direction forms a magnetic field component to be measured in the first direction, and then the second magnetic signal output circuit for measuring the magnetic flux intensity in the second direction is formed through the second magnetic induction unit, which has "a magnetic induction sensitivity direction parallel to the first direction and a projection on the plane located in the second air gap region." In addition, the first magnetic signal output circuit for measuring the magnetic flux intensity in the first direction is formed through the first magnetic induction unit, which has "a magnetic induction sensitivity direction parallel to the first direction and a projection on the plane located in the first air gap region." The multi-axis magnetic field sensor can measure the magnetic flux intensity in the first direction and the second direction by means of the first magnetic induction unit and the second magnetic induction units having the same magnetic induction sensitivity direction, without rotating the magnetic induction units, thereby making the packaging process simpler. It solves the technical problem in the prior art that "multi-axis magnetic field sensors fabricated by using magnetic induction units with different magnetic induction sensitivity directions" are prone to angular deviations during the packaging process and impose high requirements for the packaging process.

Optionally, in the embodiments of the present application, the conversion magnetic circuit comprises a first conversion magnetic circuit and a second conversion magnetic circuit that are adjacent to each other; the first conversion magnetic circuit has a first conversion air gap in the second direction, and the second conversion magnetic circuit has a second conversion air gap in the second direction; the second magnetic induction unit comprises: a first conversion magnetic induction unit and a second conversion magnetic induction unit; the projection of the first conversion magnetic induction unit on the plane is located within the first conversion air gap region, and the projection of the second conversion magnetic induction unit on the plane is located within the second conversion air gap region; and the sensor forms the second magnetic signal output circuit based on the first conversion magnetic induction unit and the second conversion magnetic induction unit.

In the above-described implementation process, since the first conversion magnetic circuit and the second conversion magnetic circuit are adjacent conversion magnetic circuits in the first direction, after the magnetic field to be measured enters the "magnetic field input regions at both ends of the second magnetic conductor," magnetic field components with opposite directions will be formed at the first conversion air gap and the second conversion air gap, and the resistance values of the first conversion magnetic induction unit and the second conversion magnetic induction unit will change in opposite directions, thereby more sensitively reflecting changes in the magnetic field and improving the detection sensitivity of the multi-axis magnetic field sensor.

Optionally, in the embodiments of the present application, the sensor further comprises: a first magnetic shielding magnetic induction unit; the projection of the first magnetic shielding magnetic induction unit on the plane is located within the magnetic flux guiding region of the first magnetic conductor; wherein the magnetic induction sensitivity direction of the first magnetic shielding magnetic induction unit is the same as the magnetic induction sensitivity direction of the first magnetic induction unit or the second magnetic induction unit; and the sensor forms the first magnetic signal output circuit based on the first magnetic induction unit and the first magnetic shielding magnetic induction unit.

In the above-described implementation process, since the projection of the first magnetic shielding induction unit on the plane is located in the magnetic flux guiding region of the first magnetic conductor, what the first magnetic shielding induction unit detects is a magnetic field signal that has been weakened by the first magnetic conductor. The first magnetic shielding induction unit can be regarded as a fixed resistor, and the first magnetic signal output circuit for measuring the magnetic flux intensity in the first direction can be formed based on the first magnetic induction unit and the first magnetic shielding magnetic induction unit. The first magnetic signal output circuit formed through the first magnetic induction unit and the first magnetic shielding magnetic induction unit has low sensitivity, which can have a larger magnetic field strength detection range and realize a wide-range, low-sensitivity measurement of magnetic flux intensity in the first direction.

Optionally, in the embodiments of the present application, the sensor further comprises: a second magnetic shielding magnetic induction unit; the projection of the second magnetic shielding magnetic induction unit on the plane is located within the magnetic flux guiding region of the second magnetic conductor; wherein the magnetic induction sensitivity direction of the second magnetic shielding magnetic induction unit is the same as the magnetic induction sensitivity direction of the first magnetic induction unit or the second magnetic induction unit;

In the above-described implementation process, since the projection of the second magnetic shielding induction unit on the plane is located in the magnetic flux guiding region of the second magnetic conductor, what the second magnetic shielding induction unit detects is a magnetic field signal that has been weakened by the second magnetic conductor. The second magnetic shielding induction unit can be regarded as a resistor, and the second magnetic signal output circuit for measuring the magnetic flux intensity in the second direction can be formed based on the second magnetic induction unit and the second magnetic shielding magnetic induction unit. The second magnetic signal output circuit formed by the second magnetic induction unit and the second magnetic shielding magnetic induction unit has low sensitivity, which can have a larger magnetic field strength detection range and realize a wide-range, low-sensitivity measurement of magnetic flux intensity in the second direction.

Optionally, in the embodiments of the present application, the sensor further comprises: a first magnetic flux divider placed on the plane in the first direction; the first magnetic flux divider has a first magnetic flux dividing air gap in the second direction; and the sensor adjusts the measurement sensitivity for the magnetic flux intensity in the first direction by adjusting the width of the first magnetic flux dividing air gap and/or the number of the first magnetic flux dividing air gaps.

In the above-described implementation process, the first magnetic flux divider in the first direction has a magnetic circuit in the first direction. The magnetic circuit in the first direction will cause magnetic flux division in the first direction on the first magnetic conductor. By changing the width of the first magnetic flux dividing air gap or the number of the first magnetic flux dividing air gaps, the strength of the magnetic flux dividing effect in the first direction can be adjusted, thereby adjusting the strength of the magnetic field in the first direction entering the first magnetic conductor, and realizing the adjustment of the measurement sensitivity for the sensor for magnetic flux intensity in the first direction. Specifically, by increasing the width of the first magnetic flux dividing air gap, the magnetic flux dividing effect in the first direction can be weakened, thereby enhancing the strength of the magnetic field in the first direction entering the first magnetic conductor to improve the measurement sensitivity for the magnetic flux intensity in the first direction of the sensor; and by decreasing the width of the first magnetic flux dividing air gap, the magnetic flux dividing effect in the first direction can be enhanced, thereby reducing the strength of the magnetic field in the first direction entering the first magnetic conductor to lower the measurement sensitivity for the magnetic flux intensity in the first direction of the sensor. Alternatively, by increasing the number of the first magnetic flux dividing air gaps, the magnetic flux dividing effect in the first direction can be weakened, thereby enhancing the strength of the magnetic field in the first direction entering the first magnetic conductor to improve the measurement sensitivity for the magnetic flux intensity in the first direction of the sensor; and by decreasing the number of the first magnetic flux dividing air gaps, the magnetic flux dividing effect in the first direction can be enhanced, thereby reducing the strength of the magnetic field in the first direction entering the first magnetic conductor to lower the measurement sensitivity for the magnetic flux intensity in the first direction of the sensor.

Optionally, in the embodiments of the present application, the second magnetic conductor further comprises: a magnetic flux dividing circuit connecting the magnetic field input regions at two ends of the second magnetic conductor; the magnetic flux dividing circuit has a second magnetic flux dividing air gap in the second direction; and the sensor adjusts the measurement sensitivity for the magnetic flux intensity in the second direction by adjusting the width of the second magnetic flux dividing air gap and/or the number of the second magnetic flux dividing air gaps.

In the above-described implementation process, the magnetic flux dividing circuit connecting the magnetic field input regions at two ends of the second magnetic conductor is a magnetic flux dividing circuit in the second direction, and the magnetic flux dividing circuit in the second direction will cause magnetic flux division in the second direction on the second magnetic conductor. By changing the width of the second magnetic flux dividing air gap or the number of the second magnetic flux dividing air gaps, the strength of the magnetic flux dividing effect in the second direction can be adjusted, thereby adjusting the strength of the magnetic field in the second direction entering the first magnetic conductor, and realizing the adjustment of the measurement sensitivity for the magnetic flux intensity in the second direction of the sensor. Specifically, by increasing the width of the second magnetic flux dividing air gap, the magnetic flux dividing effect in the second direction can be weakened, thereby enhancing the strength of the magnetic field in the second direction entering the second magnetic conductor to improve the measurement sensitivity for the magnetic flux intensity in the second direction of the sensor; and by decreasing the width of the second magnetic flux dividing air gap, the magnetic flux dividing effect in the second direction can be enhanced, thereby reducing the strength of the magnetic field in the second direction entering the second magnetic conductor to lower the measurement sensitivity for the magnetic flux intensity in the second direction of the sensor. Alternatively, by increasing the number of the second magnetic flux dividing air gaps, the magnetic flux dividing effect in the second direction can be weakened, thereby enhancing the strength of the magnetic field in the second direction entering the second magnetic conductor to improve the measurement sensitivity for the magnetic flux intensity in the second direction of the sensor; and by decreasing the number of the second magnetic flux dividing air gaps, the magnetic flux dividing effect in the second direction can be enhanced, thereby reducing the strength of the magnetic field in the second direction entering the first magnetic conductor to lower the measurement sensitivity for the magnetic flux intensity in the second direction of the sensor.

Optionally, in the embodiments of the present application, the distances from the first magnetic induction unit to the first magnetic conductor and to the second magnetic conductor are both greater than a first preset distance; the sensor further comprises: a third magnetic induction unit; wherein the projection of the third magnetic induction unit on the plane is located within the magnetic flux guiding region of the first magnetic conductor and adjacent to the first air gap region, or the projection on the plane is located within the first air gap region and adjacent to the magnetic flux guiding region of the first magnetic conductor, or the projection on the plane is located within the magnetic flux guiding region of the second magnetic conductor and adjacent to the second air gap region, or the projection on the plane is located within the second air gap region and adjacent to the magnetic flux guiding region of the second magnetic conductor; and the magnetic induction sensitivity direction of the third magnetic induction unit is the same as the magnetic induction sensitivity direction of the first magnetic induction unit or the second magnetic induction unit; wherein the distance from the third magnetic induction unit to the first magnetic conductor or to the second magnetic conductor is less than a second preset distance; the second preset distance is less than the first preset distance; and the sensor forms a third magnetic signal output circuit based on the third magnetic induction unit for measuring the magnetic flux intensity in a third direction; wherein the third direction is perpendicular to the plane.

In the above-described implementation process, due to the magnetic flux concentration effect of the first magnetic conductor or the second magnetic conductor on the magnetic field in the third direction, the magnetic field will be distorted at the edge of the magnetic flux guiding region when entering and exiting the magnetic flux guiding region of the first magnetic conductor or the second magnetic conductor; therefore, a magnetic field to be measured in the third direction will generate a magnetic field component in the first direction or the second direction at the edge of the magnetic flux guiding regions of the first magnetic conductor and the second magnetic conductor. Since "the magnetic induction sensitivity direction of the third magnetic induction unit is the same as the magnetic induction sensitivity direction of the first magnetic induction unit or the second magnetic induction unit," and "a magnetic field to be measured in the third direction will generate a magnetic field component in the first direction or the second direction at the edge of the magnetic flux guiding regions of the first magnetic conductor and the second magnetic conductor," the third magnetic induction unit will be affected by the magnetic field component in the first direction or the second direction when adjacent to the edge of the magnetic flux guiding region, and a third magnetic signal output circuit for measuring the magnetic flux intensity in the third direction can be formed through the third magnetic induction unit. The multi-axis magnetic field sensor can measure the magnetic flux intensity in the first direction, the second direction, and the third direction by means of the first magnetic induction unit, the second magnetic induction units, and the third magnetic induction unit having the same magnetic induction sensitivity direction, without rotating the magnetic induction units, thereby making the packaging process simpler.

Optionally, in the embodiments of the present application, the sensor further comprises: an external magnetic field induction unit; the magnetic induction sensitivity direction of the external magnetic field induction unit is the same as the magnetic induction sensitivity direction of the first magnetic induction unit or the second magnetic induction unit, and the distances from the external magnetic field induction unit to the first magnetic conductor and to the second magnetic conductor are both greater than a third preset distance; the sensor forms the first magnetic signal output circuit based on the external magnetic field induction unit and the first magnetic induction unit; and the sensor forms the second magnetic signal output circuit based on the external magnetic field induction unit and the second magnetic induction unit.

In the above-described implementation process, since the distances from the external magnetic field magnetic induction unit to the first magnetic conductor and to the second magnetic conductor are relatively far, the external magnetic field magnetic induction unit will be directly affected by an external magnetic field (relative to the magnetic field inside the first magnetic conductor and to the second magnetic conductor, the external magnetic field refers to an external magnetic field to be measured). The first magnetic signal output circuit formed through the external magnetic field induction unit and the first magnetic induction unit has low sensitivity, which can have a larger magnetic field strength detection range and realize a wide-range, low-sensitivity measurement of magnetic flux intensity in the first direction. Similarly, through the second magnetic signal output formed by the external magnetic field induction unit and the second magnetic induction unit, a wide-range, low-sensitivity measurement of magnetic flux intensity in the second direction can be realized.

Optionally, in the embodiments of the present application, the sensor further includes: a resistor (preferably a fixed resistor); the sensor forms the first magnetic signal output circuit based on the resistor and the first magnetic induction unit; and the sensor forms the second magnetic signal output circuit based on the resistor and the second magnetic induction unit.

In the above implementation process, the first magnetic signal output circuit for measuring the magnetic flux intensity in the first direction can be formed through the resistor and the first magnetic induction unit, and the second magnetic signal output circuit for measuring the magnetic flux intensity in the second direction can be formed through the resistor and the second magnetic induction unit. The output circuit structure of this multi-axis magnetic field sensor is simpler, which can reduce the actual process packaging difficulty. In addition, the first magnetic signal output circuit formed through the resistor and the first magnetic induction unit has low sensitivity, which can have a larger magnetic field strength detection range and realize a wide-range, low-sensitivity measurement of magnetic flux intensity in the first direction. Similarly, through the second magnetic signal output formed by the resistor and the second magnetic induction unit, a wide-range, low-sensitivity measurement of magnetic flux intensity in the second direction can be realized.

Optionally, in the embodiments of the present application, the sensor further comprises: an open-loop signal conditioning circuit; the open-loop signal conditioning circuit is electrically connected to the first magnetic signal output circuit and the second magnetic signal output circuit respectively; the sensor performs conditioning and amplification, temperature compensation, and/or linearity correction on electrical signals output by the first magnetic signal output circuit and the second magnetic signal output circuit based on the open-loop signal conditioning circuit to obtain a first conditioning signal, and outputs the first conditioning signal; alternatively, the sensor further comprises: a closed-loop signal conditioning circuit and a magnetic field feedback coil; the sensor forms a closed-loop magnetic field feedback structure based on the closed-loop signal conditioning circuit, the magnetic field feedback coil, and the magnetic induction units; the sensor performs conditioning and amplification, temperature compensation, and/or linearity correction on electrical signals output by the first magnetic signal output circuit and the second magnetic signal output circuit based on the closed-loop magnetic field feedback structure, generates a feedback magnetic field to achieve dynamic magnetic field balance and obtain a second conditioning signal, and outputs the second conditioning signal; wherein the second conditioning signal represents a feedback current of the magnetic field feedback coil reaching a state of dynamic magnetic field balance.

In the above implementation process, after the signal conditioning circuit (the open-loop signal conditioning circuit/the closed-loop signal conditioning circuit and the magnetic field feedback coil) performs conditioning and amplification, temperature compensation, and/or linearity correction on electrical signals output by the first magnetic signal output circuit and the second magnetic signal output circuit, a conditioned standard signal can be obtained to ensure that the conditioned standard signal can be more accurately identified by a corresponding magnetic detection system, so as to obtain a more accurate magnetic field detection result based on the multi-axis magnetic field sensor.

The multi-axis magnetic field sensor according to the present application can measure the magnetic flux intensity in the first direction and the second direction by means of the first magnetic induction unit and the second magnetic induction units having the same magnetic induction sensitivity direction, without rotating the magnetic induction units, thereby making the packaging process simpler. It solves the technical problem in the prior art that "multi-axis magnetic field sensors fabricated by using magnetic induction units with different sensitivity directions" are prone to angular deviations during the packaging process and impose high requirements for the packaging process.

### Brief Description of the Accompanying Drawings

In order to more clearly illustrate the technical solutions in the embodiments of the present application, the drawings required in the embodiments of the present application will be briefly introduced below. It should be understood that the drawings described below are merely some embodiments of the present application and should not be construed as limitations to the scope. Those skilled in the art may derive additional drawings based on these drawings without any creative work.
FIG. 1 is a structural schematic diagram of a projection of a first type of multi-axis magnetic field sensor on a plane according to the embodiments of the present application;
FIG. 2 is a simulation diagram of a first type of magnetic flux path according to the embodiments of the present application;
FIG. 3 is a simulation diagram of a second type of magnetic flux path according to the embodiments of the present application;
FIG. 4 is a structural schematic diagram of a projection of a second type of multi-axis magnetic field sensor on a plane according to the embodiments of the present application;
FIG. 5 is a simulation diagram of a third type of magnetic flux path according to the embodiments of the present application;
FIG. 6 is a simulation diagram of a fourth type of magnetic flux path according to the embodiments of the present application;
FIG. 7 is a structural schematic diagram of a projection of a third type of multi-axis magnetic field sensor on a plane according to the embodiments of the present application;
FIG. 8 is a simulation diagram of a fifth type of magnetic flux path according to the embodiments of the present application;
FIG. 9 is a simulation diagram of a sixth type of magnetic flux path according to the embodiments of the present application;
FIG. 10 is a structural schematic diagram of a projection of a fourth type of multi-axis magnetic field sensor on a plane according to the embodiments of the present application;
FIG. 11 is a structural schematic diagram of a projection of a fifth type of multi-axis magnetic field sensor on a plane according to the embodiments of the present application.

### Detailed Description of Specific Embodiments

Embodiments of the technical solution of the present application will be described in detail below with reference to the accompanying drawings. The following embodiments are only used to illustrate the technical solution of the present application more clearly, and are therefore only examples and should not be used to limit the scope of protection of the present application.

Unless otherwise defined, all technical and scientific terms used herein have the same meaning as commonly understood by one of ordinary skill in the art to which the present application belongs; the terminology used herein is merely for the purpose of describing particular embodiments and is not intended to limit the present application.

In the description of the embodiments of the present application, the technical terms "first," "second," etc. are used only to distinguish different objects and should not be construed as indicating or implying relative importance or implicitly indicating the number, specific order, or primary and secondary relationship of the indicated technical features. In the description of the embodiments of the present application, "multiple" means two or more, unless otherwise explicitly specified.

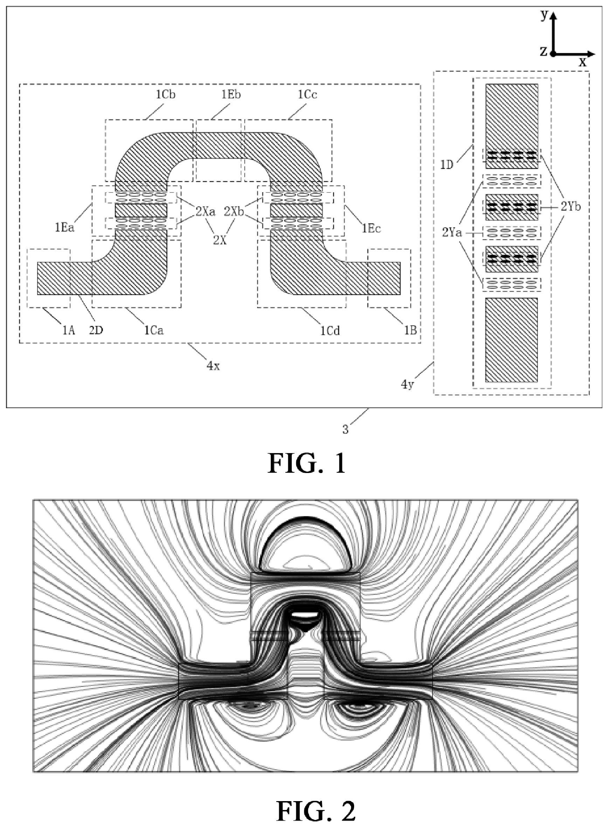

FIG. 1 is a structural schematic diagram of a projection of a first type of multi-axis magnetic field sensor on a plane according to the embodiments of the present application. As shown in FIG. 1, the multi-axis magnetic field sensor comprises:
a first magnetic conductor 1D in a first direction, the first magnetic conductor 1D having a first air gap in a second direction; wherein the first direction and the second direction are perpendicular to each other;
a second magnetic conductor 2D located in the same plane (substrate 3) as the first magnetic conductor 1D, the second magnetic conductor 2D comprising: magnetic field input regions (1A and 1B) located in the second direction and at two ends of the second magnetic conductor 2D and magnetic field conversion regions (1Ca, 1Cb, 1Cc, 1Cd, 1Ea, 1Eb, and 1Ec) located between the two ends of the second magnetic conductor 2D, in which the magnetic field conversion regions (1Ca, 1Cb, 1Cc, 1Cd, 1Ea, 1Eb, and 1Ec) comprise a conversion magnetic circuit in the first direction; wherein the conversion magnetic circuit has a second air gap in the second direction;
a first magnetic induction unit 2Ya, the projection of the first magnetic induction unit 2Ya on the plane 1 being located in the first air gap region; the sensor forming, based on the first magnetic induction unit 2Ya, a first magnetic signal output circuit for measuring the magnetic flux intensity in the first direction;
second magnetic induction units 2X, the projections of the second magnetic induction units 2X on the plane (substrate 3) being located in the second air gap region; the sensor forming, based on the second magnetic induction units 2X, a second magnetic signal output circuit for measuring the magnetic flux intensity in the second direction;
wherein the first magnetic induction unit 2Ya and the second magnetic induction units 2X have the same magnetic induction sensitivity direction, which is parallel to the first direction.

Here, the aforementioned plane can be a PCB substrate (e.g., the substrate 3 shown in FIG. 1) or a wafer substrate. The first magnetic conductor 1D and the second magnetic conductor 2D can be magnetic flux guiding regions formed on a plane by soft magnetic materials, such as silicon steel sheets, low-carbon steel, or iron-silicon alloys. Specifically, the first magnetic conductor 1D and the second magnetic conductor 2D are magnetic flux guiding regions formed by at least two segments of soft magnetic material, and the first air gap and the second air gap refer to the gap between the two segments of soft magnetic material; and the first air gap and the second air gap can be gaps formed by the air or other non-magnetic materials. The number of first air gaps can be one or more, the number of second air gaps can also be one or more, and the present application does not impose any specific limitation on this. The first magnetic induction unit 2Ya and the second magnetic induction unit 2X can be implemented by giant magnetoimpedance (GMI), fluxgate, or magnetoresistance sensitive elements; wherein the magnetoresistance sensitive elements comprise anisotropic magnetoresistance (AMR), giant magnetoresistance (GMR), tunnel magnetoresistance (TMR), colossal magnetoresistance, etc.

Here, a first magnetic signal output circuit may be formed based on the first magnetic induction unit 2Ya and a resistor, or a first magnetic signal output circuit may also be formed based on the first magnetic induction unit 2Ya and a "magnetic induction unit with a projection on the plane located within the magnetic flux guiding region of the first magnetic conductor." Correspondingly, a first magnetic signal output circuit may be formed based on the second magnetic induction unit 2X and a resistor, or a second magnetic signal output circuit may also be formed based on the second magnetic induction unit 2X and a "magnetic induction unit with a projection on the plane located within the magnetic flux guiding region of the second magnetic conductor." The first magnetic signal output circuit and the second magnetic signal output circuit can be differential half-bridge or differential full-bridge output circuits.

The plane where the substrate 3 shown in FIG. 1 is located is used as the X-Y plane, the first direction is the Y-axis direction, the left side is the magnetic field measurement region 4x in the X-axis direction, and the right side is the magnetic field measurement region 4y in the Y-axis direction. XY direction conversion region 1Ca is a corner pointing to the negative X-axis direction and positive Y-axis direction, XY direction conversion region 1Cb is a corner pointing to the positive X-axis direction and negative Y-axis direction, XY direction conversion region 1Cc is a corner pointing to the negative X-axis direction and negative Y-axis direction, and XY direction conversion region 1Cd is a corner pointing to the positive X-axis direction and positive Y-axis direction; magnetic flux path connection region 1Ea connects XY direction conversion regions 1Ca and 1Cb in the Y-axis direction, magnetic flux path connection region 1Eb connects XY direction conversion regions 1Cb and 1Cc in the X-axis direction, and magnetic flux path connection region 1Ec connects XY direction conversion regions 1Cc and 1Cd in the Y-axis direction. The magnetic flux path connection regions 1Ea and 1Ec are respectively provided with two second air gaps that penetrate the soft magnetic material along the X-axis direction; and the first magnetic conductor 1D is provided with a first air gap that penetrates the soft magnetic material along the X-axis direction.

Here, the second magnetic conductor 2D comprises magnetic field input regions (1A and 1B) located at two ends of the second magnetic conductor 2D and in the second direction (X-axis direction). Specifically, 1A is the magnetic field input region when the external magnetic field is in the positive X-axis direction, and 1B is the magnetic field input region when the external magnetic field is in the negative X-axis direction. When the external magnetic field is in the positive X-axis direction, 1A serves as the magnetic field input region in the positive X-axis direction, and at this moment, the magnetic field input region 1B acts as the magnetic field output region of the magnetic field (the external magnetic field in the positive X-axis direction). When the external magnetic field is in the negative X-axis direction, 1B serves as the magnetic field input region in the negative X-axis direction, and at this moment, the magnetic field input region 1A acts as the magnetic field output region of the magnetic field (the external magnetic field in the negative X-axis direction).

Specifically, description will be made by taking the direction of the external magnetic field being the positive X-axis direction, and the first magnetic conductor 1D and the second magnetic conductor 2D being made of soft magnetic metal materials as an example. At this moment, the external magnetic field enters the second magnetic conductor 2D from the magnetic field input region 1A, the soft magnetic metal material concentrates and amplifies the external magnetic field and forms a magnetic flux path, this magnetic circuit enters from the magnetic field input region 1A at the negative X-axis end of the X-axis magnetic field measurement region 4x, the XY direction conversion region 1Ca then twists the magnetic circuit to the positive Y-axis direction, it subsequently passes through the magnetic flux path connection region 1Ea with a second air gap along the positive Y-axis direction, and a magnetic field component in the positive Y-axis direction is generated in the second air gap; after passing through the XY direction conversion region 1Cb, the magnetic flux path connection region 1Eb, and the XY direction conversion region 1Cc, the magnetic circuit is twisted from the positive Y-axis direction and reversed to the negative Y-axis direction, it passes through the magnetic flux path connection region 1Ec with an air gap, and a magnetic field component in the negative Y-axis direction is generated in the air gap; and then, the magnetic circuit is twisted back to the positive X-axis direction by the XY direction conversion region 1Cd, and finally returns to the external magnetic field through the magnetic field input region 1B. As a result, a magnetic field to be measured in the positive X-axis direction can generate opposite magnetic field components in the positive and negative Y-axis directions in air gaps at different locations, thereby forming a differential magnetic field.

When the direction of the external magnetic field is the negative X-axis direction, it will enter the magnetic field input region 1B, pass through the magnetic field conversion regions (1Ca, 1Cb, 1Cc, 1Cd, 1Ea, 1Eb and 1Ec) to the magnetic field input region 1A, and return to the external magnetic field from the magnetic field input region 1A. Specifically, opposite magnetic field components in the positive and negative Y-axis directions are generated through the conversion magnetic circuit in air gaps at different locations, thereby forming a differential magnetic field.

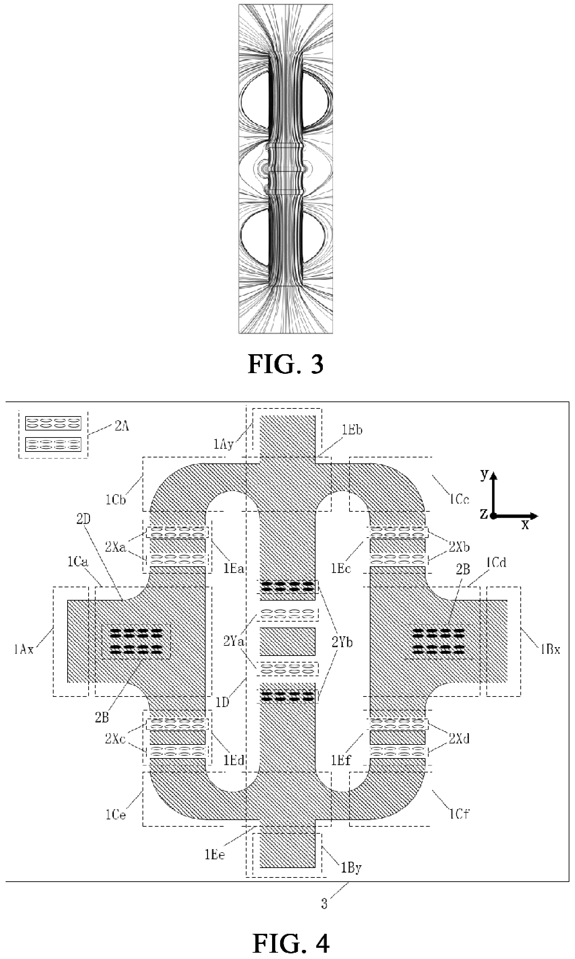

Specifically, for the X-axis magnetic field measurement region 4x with the magnetic field induction direction being the X-axis direction, the second magnetic induction unit comprises a magnetic induction unit 2Xa and a magnetic induction unit 2Xb. Taking the magnetic induction units 2Xa and 2Xb with the sensitivity directions both in the positive Y-axis direction and the external magnetic field being in the positive X-axis direction as an example, the magnetic circuit that has been concentrated and amplified passes through the magnetic flux path connection region 1Ea with an air gap along the positive Y-axis direction, and then passes through the magnetic flux path connection region 1Ec with an air gap along the negative Y-axis direction; at this moment, a magnetic field component in the positive Y-axis direction is generated in the air gap of the magnetic flux path connection region 1Ea, and a magnetic field component in the negative Y-axis direction is generated in the air gap of the magnetic flux path connection region 1Ec. Since the sensitivity directions of the magnetic induction units 2Xa and 2Xb are both in the positive Y-axis direction, the resistance value of the magnetic induction unit 2Xa decreases, while the resistance value of the magnetic induction unit 2Xb increases. Furthermore, a push-pull half-bridge structure (the second magnetic signal output circuit) can be used to sense the magnetic field in the positive X-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the second magnetic signal output circuit for detecting the second direction (i.e., the X-axis direction); or a closed-loop magnetic field feedback structure can be constructed by using a closed-loop signal conditioning circuit, a magnetic field feedback coil, and a second magnetic induction unit 2X; after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the second magnetic signal output circuit for detecting the second direction (i.e., the X-axis direction). FIG. 2 is a simulation diagram of a first type of magnetic flux path according to the embodiments of the present application. Specifically, FIG. 2 is a simulation diagram of the magnetic flux path after applying a magnetic field to be measured in the positive X-axis direction to the X-axis magnetic field measurement region 4x in the embodiment provided in FIG. 1. It can be seen that the magnetic field to be measured is concentrated and amplified by the soft magnetic metal material to form a magnetic circuit, and is twisted sequentially at the XY direction conversion regions 1Ca, 1Cb, 1Cc, and 1Cd. At the air gaps of the magnetic flux path connection regions 1Ea and 1Ec, distinct opposite magnetic field components in the positive and negative Y-axis directions can be generated to form a differential magnetic field, and the magnetic flux paths through the aforementioned air gaps are connected in series. FIG. 3 is a simulation diagram of a second type of magnetic flux path according to the embodiments of the present application. Specifically, FIG. 3 is a simulation diagram of the magnetic flux path after applying a magnetic field to be measured in the positive Y-axis direction to the Y-axis magnetic field measurement region 4y in the embodiment provided in FIG. 1; and it can be seen that the magnetic field to be measured is concentrated and amplified by the soft magnetic metal material to form a magnetic circuit and pass through the air gap of the Y-direction magnetic flux guiding region 1D along the Y-axis direction.

Since all the magnetic induction units of the multi-axis magnetic field sensor provided in this embodiment have the same sensitivity direction, a magnetoresistive sensitive element, such as tunnel magnetoresistive (TMR), with a sensitivity direction parallel to its own plane, can be selected as the magnetic induction unit (the first magnetic induction unit 2Ya or the second magnetic induction unit 2X), which is combined with lead pads and mechanical support housing, and a single-chip integrated fabrication process is adopted.

Therefore, the multi-axis magnetic field sensor according to the present application can measure the magnetic flux intensity in the first direction and the second direction by means of the first magnetic induction unit 2Ya and the second magnetic induction units 2X having the same magnetic induction sensitivity direction, without rotating the magnetic induction units, thereby making the packaging process simpler. Specifically, the magnetic flux intensity in the first direction can be measured by using either "the first magnetic induction unit 2Ya and a resistor" or "the first magnetic induction unit 2Ya and an external magnetic field magnetic induction unit for detecting the magnetic flux intensity of the external magnetic field." It solves the technical problem in the prior art that "multi-axis magnetic field sensors fabricated by using magnetic induction units with different sensitivity directions" are prone to angular deviations during the packaging process and impose high requirements for the packaging process.

It should be noted that for the same soft magnetic metal material structure, there may be multiple ways to define the magnetic flux path connection region 1E (1Ea, 1Eb, 1Ec); in the case described above, the magnetic field input region 1A and the XY direction conversion region 1Ca in FIG. 1 can be considered as directly connected, or they can be considered as having a section of the magnetic flux path connection region 1E; furthermore, the XY direction conversion region 1Cb, the magnetic flux path connection region 1Eb, and the XY direction conversion region 1Cc are connected in sequence in FIG. 1, and when the corner distance between the XY direction conversion region 1Cb and the XY direction conversion region 1Cc is too close, it can be considered that the XY direction conversion regions 1Cb and 1Cc are directly connected; likewise, the part of the soft magnetic metal material provided with an air gap can be considered as being located in the magnetic flux path connection region 1E (1Ea or 1Ec), or it can be considered as being located in the XY direction conversion region 1C (1Ca, 1Cb, 1Cc or 1Cd). The above descriptions are all schematic representations of the structures of the embodiments of the present application. Only one relatively clear definition method among the descriptions of the embodiments of the present application is selected for easy illustration, and only one of the description methods of the embodiments is selected.

In some optional embodiments, the conversion magnetic circuit comprises a first conversion magnetic circuit 1Ea and a second conversion magnetic circuit 1Ec that are adjacent to each other; the first conversion magnetic circuit 1Ea has a first conversion air gap in the second direction, and the second conversion magnetic circuit 1Ec has a second conversion air gap in the second direction; the second magnetic induction unit 2X comprises: a first conversion magnetic induction unit 2Xa and a second conversion magnetic induction unit 2Xb; the projection of the first conversion magnetic induction unit 2Xa on the plane (the substrate 3) is located within the first conversion air gap region, and the projection of the second conversion magnetic induction unit 2Xb on the plane (the substrate 3) is located within the second conversion air gap region; and the sensor forms the second magnetic signal output circuit based on the first conversion magnetic induction unit 2Xa and the second conversion magnetic induction unit 2Xb.

FIG. 4 is a structural schematic diagram of a projection of a second type of multi-axis magnetic field sensor on a plane according to the embodiments of the present application.

In some optional embodiments, the sensor further comprises: a first magnetic shielding magnetic induction unit 2Yb; the projection of the first magnetic shielding magnetic induction unit 2Yb on the plane (the substrate 3) is located within the magnetic flux guiding region of the first magnetic conductor 1D; wherein the magnetic induction sensitivity direction of the first magnetic shielding magnetic induction unit 2Yb is the same as the magnetic induction sensitivity direction of the first magnetic induction unit 2Ya or the second magnetic induction unit 2X; and the sensor forms the first magnetic signal output circuit based on the first magnetic induction unit 2Ya and the first magnetic shielding magnetic induction unit 2Yb.

Here, referring to FIG. 1 and FIG. 4, for the Y-axis magnetic field measurement region 4y with the magnetic field induction direction being the Y-axis direction, taking the first magnetic induction unit 2Ya and the first magnetic shielding magnetic induction unit 2Yb with the sensitivity direction being the positive Y-axis direction and the external magnetic field being in the positive Y-axis direction as an example, the magnetic circuit that has been concentrated and amplified passes through the Y-direction magnetic field guiding region (the first magnetic conductor) 1D with an air gap along the positive Y-axis direction, and generates a magnetic field component in the positive Y-axis direction in the air gap. Since the sensitivity directions of the first magnetic induction unit 2Ya and the first magnetic shielding magnetic induction unit 2Yb are both in the positive Y-axis direction, the resistance value of the first magnetic induction unit 2Ya decreases, while as the first magnetic shielding magnetic induction unit 2Yb detects the magnetic field weakened by the shielding of the soft magnetic metal material, the resistance value of the first magnetic shielding magnetic induction unit 2Yb can be considered to be approximately unchanged. Therefore, based on the first magnetic induction unit 2Ya and the first magnetic shielding magnetic induction unit 2Yb, a differential half-bridge structure can be used to sense the magnetic field in the positive Y-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the first magnetic signal output circuit for detecting the first direction (i.e., the Y-axis direction); or a closed-loop magnetic field feedback structure can be constructed by using a closed-loop signal conditioning circuit, a magnetic field feedback coil, and a magnetic induction unit (the first magnetic induction unit 2Ya and the first magnetic shielding magnetic induction unit 2Yb); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the first magnetic signal output circuit for detecting the first direction (i.e., the Y-axis direction).

Therefore, the multi-axis magnetic field sensor according to the present application can measure the magnetic flux intensity in the first direction and the second direction by means of the first magnetic induction unit 2Ya, the first magnetic shielding magnetic induction unit 2Yb, and the second magnetic induction units 2X having the same magnetic induction sensitivity direction, without rotating the magnetic induction units, thereby making the packaging process simpler. It solves the technical problem in the prior art that "multi-axis magnetic field sensors fabricated by using magnetic induction units with different sensitivity directions" are prone to angular deviations during the packaging process and impose high requirements for the packaging process.

In some optional embodiments, the sensor further comprises: a second magnetic shielding magnetic induction unit 2B; the projection of the second magnetic shielding magnetic induction unit 2B on the plane (the substrate 3) is located within the magnetic flux guiding region of the second magnetic conductor 2D; wherein the magnetic induction sensitivity direction of the second magnetic shielding magnetic induction unit 2B is the same as the magnetic induction sensitivity direction of the first magnetic induction unit 2Y or the second magnetic induction unit 2X; and the sensor forms the second magnetic signal output circuit based on the second magnetic induction unit 2X and the second magnetic shielding magnetic induction unit 2B.

Here, as shown in FIG. 4, the second magnetic conductor 2D comprises magnetic field input regions (1Ax, 1Bx), XY direction conversion regions (1Ca, 1Cb, 1Cc, 1Cd, 1Ce, 1Cf), and magnetic flux path connection regions (1Ea, 1Eb, 1Ec, 1Ed, 1Ee, 1Ef). The first magnetic conductor 1D comprises magnetic field input regions (1Ay, 1By) and magnetic flux path connection regions (1Eb, 1Ee) shared with the second magnetic conductor 2D.

Here, the first magnetic conductor 1D and the second magnetic conductor 2D may be made of soft magnetic metal materials, the XY direction conversion region 1Ca comprises three ports pointing to the negative X-axis direction, the positive Y-axis direction, and the negative Y-axis direction and is connected with the magnetic field input region 1Ax, the XY direction conversion region 1Cb is a corner pointing to the positive X-axis direction and the negative Y-axis direction, the XY direction conversion region 1Cc is a corner pointing to the negative X-axis direction and the negative Y-axis direction, the XY direction conversion region 1Cd comprises three ports pointing to the positive X-axis direction, the positive Y-axis direction, and the negative Y-axis direction and is connected with the magnetic field input region 1Bx, the XY direction conversion region 1Ce is a corner pointing to the positive X-axis direction and the positive Y-axis direction, and the XY direction conversion region 1Cf is a corner pointing to the negative X-axis direction and the positive Y-axis direction. The magnetic flux path connection region 1Ea connects to the XY direction conversion regions 1Ca and 1Cb in the Y-axis direction; the magnetic flux path connection region 1Eb connects to the XY direction conversion regions 1Cb and 1Cc in the X-axis direction, and connects to the magnetic field input region 1Ay and the Y-direction magnetic flux guiding region 1D in the Y-axis direction; the magnetic flux path connection region 1Ec connects to the XY direction conversion regions 1Cc and 1Cd in the Y-axis direction; the magnetic flux path connection region 1Ed connects to the XY direction conversion regions 1Ca and 1Ce in the Y-axis direction; the magnetic flux path connection region 1Ee connects to the XY direction conversion regions 1Ce and 1Cf in the X-axis direction, and connects to the magnetic field input region 1By and the Y-direction magnetic flux guiding region 1D in the Y-axis direction; the magnetic flux path connection region 1Ef connects to the XY direction conversion regions 1Cd and 1Cf in the Y-axis direction; wherein the magnetic flux path connection regions 1Ea, 1Ec, 1Ed, 1Ef and the Y-direction magnetic flux guiding region 1D are each provided with two air gaps that penetrate the soft magnetic metal material along the X-axis direction.

Specifically, the description is provided assuming that the external magnetic field is in the positive X-axis direction. At this moment, the soft magnetic metal material concentrates and amplifies the external magnetic field and forms a magnetic flux path, this magnetic circuit enters from the magnetic field input region 1Ax, the XY direction conversion region 1Ca then divides the magnetic circuit into two sides and twists them to the positive Y-axis direction and the negative Y-axis direction, and the two magnetic circuits are mirror-symmetric with respect to the X-axis and connected in parallel. One of the magnetic circuits passes through the magnetic flux path connection region 1Ea with a second air gap along the positive Y-axis direction, and a magnetic field component in the positive Y-axis direction is generated in the second air gap; the magnetic circuit then passes through the XY direction conversion region 1Cb, the magnetic flux path connection region 1Eb, and the XY direction conversion region 1Cc in sequence, and after twisting the magnetic circuit from the positive Y-axis direction and reversing it to the negative Y-axis direction, it then passes through the magnetic flux path connection region 1Ec with a second air gap, and a magnetic field component in the negative Y-axis direction is generated in the second air gap. The other magnetic circuit passes through the magnetic flux path connection region 1Ed with a second air gap along the negative Y-axis direction, and a magnetic field component in the negative Y-axis direction is generated in the second air gap; the magnetic circuit then passes through the XY direction conversion region 1Ce, the magnetic flux path connection region 1Ee, and the XY direction conversion region 1Cf in sequence, and after twisting the magnetic circuit from the negative Y-axis direction and reversing it to the positive Y-axis direction, it then passes through the magnetic flux path connection region 1Ef with a second air gap, and a magnetic field component in the positive Y-axis direction is generated in the second air gap. As a result, a magnetic field to be measured in the X-axis direction can be made to generate opposite magnetic field components in the positive and negative Y-axis directions in air gaps at different locations, thereby forming a differential magnetic field; finally, the two magnetic circuits in the positive and negative Y-axis directions are twisted back to the positive X-axis direction by the XY direction conversion region 1Cd, and then enter the external magnetic field through the magnetic field input region 1Bx.

When the direction of the external magnetic field is the negative X-axis direction, it will enter the magnetic field input region 1Bx, pass through the magnetic field conversion regions (1Ca, 1Cb, 1Cc, 1Cd, 1Ce, 1Cf) and the magnetic flux path connection regions (1Ea, 1Eb, 1Ec, 1Ed, 1Ee, 1Ef) to the magnetic field input region 1Ax, and return to the external magnetic field from the magnetic field input region 1Ax. Specifically, opposite magnetic field components in the positive and negative Y-axis directions are generated through the conversion magnetic circuit in second air gaps at different locations, thereby forming a differential magnetic field.

Specifically, for the X-axis magnetic field measurement region 4x with the magnetic field induction direction being the X-axis direction, the second magnetic induction unit comprises a magnetic induction unit 2Xa, a magnetic induction unit 2Xb, a magnetic induction unit 2Xc, and a magnetic induction unit 2Xd. Taking the sensitivity directions of all the second magnetic induction units being the positive Y-axis direction and the external magnetic field being in the positive X-axis direction as an example, a magnetic field component in the positive Y-axis direction is generated in the air gaps of the magnetic flux path connection regions 1Ea and 1Ef, and a magnetic field component in the negative Y-axis direction is generated in the air gaps of the magnetic flux path connection regions 1Ec and 1Ed. Since the sensitivity directions of the second magnetic induction units 2Xa, 2Xb, 2Xc, and 2Xd are all in the positive Y-axis direction, the resistance values of the second magnetic induction units 2Xa and 2Xd decrease, while the resistance values of the second magnetic induction units 2Xb and 2Xc increase. Therefore, the second magnetic induction units 2Xa, 2Xb, 2Xc, and 2Xd can be connected in series or parallel to form a push-pull half-bridge or push-pull full-bridge structure to sense a magnetic field in the positive X-axis direction and generate a differential voltage signal; alternatively, the second magnetic induction units 2Xa, 2Xb, 2Xc, or 2Xd can be selected to form, together with the second magnetic shielding magnetic induction unit 2B, a differential half-bridge or differential full-bridge structure to sense a magnetic field in the positive X-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the second magnetic signal output circuit for detecting the second direction (i.e., the X-axis direction); or a closed-loop magnetic field feedback structure can be constructed by using a closed-loop signal conditioning circuit, a magnetic field feedback coil, and a magnetic induction unit (the second magnetic induction units 2Xa, 2Xb, 2Xc, and 2Xd and the second magnetic shielding magnetic induction unit 2B); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the second magnetic signal output circuit for detecting the second direction (i.e., the X-axis direction).

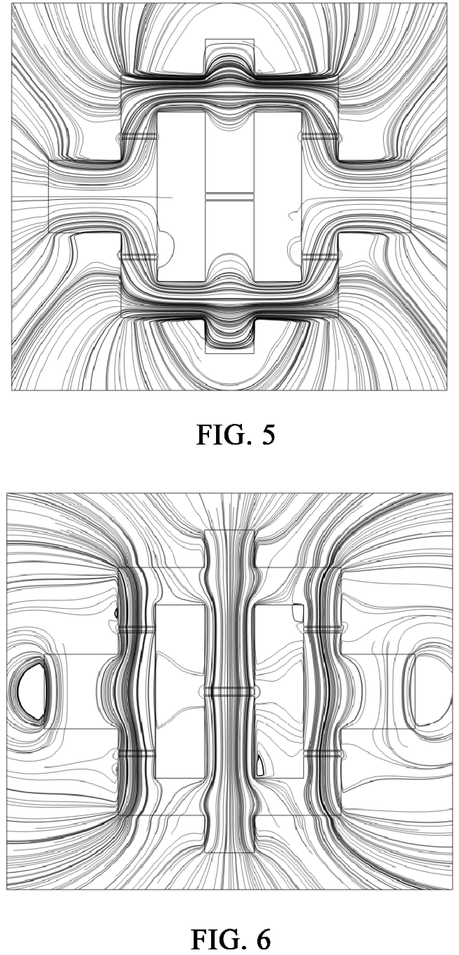

FIG. 5 is a simulation diagram of a third type of magnetic flux path according to the embodiments of the present application. Specifically, FIG. 5 is a simulation diagram of the magnetic flux path after applying a magnetic field to be measured in the positive X-axis direction to the X-axis magnetic field measurement region 4x in the embodiment provided in FIG. 4; and it can be seen that the magnetic field to be measured is concentrated and amplified by the soft magnetic metal material to form a magnetic circuit, which is divided into two sides and twisted to the positive Y-axis direction and the negative Y-axis direction to form two magnetic circuits connected in parallel; and then the two magnetic circuits are respectively twisted and reversed in the Y-axis direction, and then twisted back to the positive X-axis direction. In addition, at the air gaps of the magnetic flux path connection regions 1Ea, 1Ec, 1Ed, and 1Ef, distinct opposite magnetic field components in the positive and negative Y-axis directions can be generated to form a differential magnetic field, and the magnetic circuit substantially does not pass through the first magnetic conductor 1D. Since the magnetic circuit generated by the external magnetic field in the X-axis direction substantially does not pass through the first magnetic conductor 1D, the influence of the external magnetic field in the X-axis direction on the Y-axis measurement can be ignored.

FIG. 6 is a simulation diagram of a fourth type of magnetic flux path according to the embodiments of the present application. Specifically, FIG. 6 is a simulation diagram of the magnetic flux path after applying a magnetic field to be measured in the negative Y-axis direction to the Y-axis magnetic field measurement region 4y in the embodiment provided in FIG. 4. The magnetic circuit that has been concentrated and amplified passes through the first magnetic conductor 1D provided with an air gap along the negative Y-axis direction, and generates a magnetic field component in the negative Y-axis direction in the first air gap. Since the sensitivity directions of the first magnetic induction unit 2Ya and the first magnetic shielding magnetic induction unit 2Yb are both in the positive Y-axis direction, the resistance value of the first magnetic induction unit 2Ya increases, while as the first magnetic shielding magnetic induction unit 2Yb detects the magnetic field weakened by the shielding of the soft magnetic metal material, the resistance value can be considered to be approximately unchanged. Therefore, a differential half-bridge or differential full-bridge structure can be used to sense the magnetic field in the negative Y-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the first magnetic signal output circuit for detecting the first direction (i.e., the Y-axis direction); or a closed-loop magnetic field feedback structure can be constructed by using a closed-loop signal conditioning circuit, a magnetic field feedback coil, and a magnetic induction unit (the first magnetic induction unit 2Ya and the first magnetic shielding magnetic induction unit 2Yb); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the first magnetic signal output circuit for detecting the first direction (i.e., the Y-axis direction).

As can be seen from the above analysis of FIG. 6, all magnetic fields generated by the magnetic circuit, which is generated by the external magnetic field in the Y-axis direction, at the air gaps of the magnetic flux path connection regions 1Ea, 1Ec, 1Ed, and 1Ef used for X-axis measurement are in the negative Y-axis direction. Therefore, when the magnetic flux path connection regions 1Ea, 1Ec, 1Ed, and 1Ef form a push-pull half-bridge or push-pull full-bridge structure, the external magnetic field in the Y-axis direction will basically not affect the differential voltage signal generated by the bridge. Thus, this multi-axis magnetic field sensor has the characteristics of strong anti-interference capability.

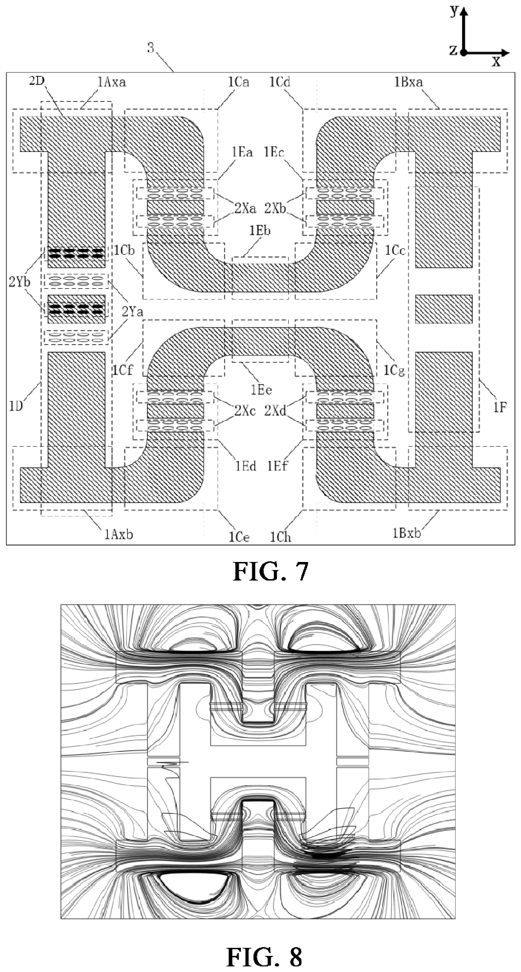

FIG. 7 is a structural schematic diagram of a projection of a third type of multi-axis magnetic field sensor on a plane according to the embodiments of the present application.

In some optional embodiments, the sensor further comprises: a first magnetic flux divider 1F placed on the plane (the substrate 3) in the first direction; the first magnetic flux divider 1F has a first magnetic flux dividing air gap in the second direction; and the sensor adjusts the measurement sensitivity for the magnetic flux intensity in the first direction by adjusting the width of the first magnetic flux dividing air gap.

Here, as shown in FIG. 7, the second magnetic conductor 2D comprises magnetic field input regions (1Axa, 1Axb, 1Bxa, 1Bxb), XY direction conversion regions (1Ca, 1Cb, 1Cc, 1Cd, 1Ce, 1Cf, 1Cg, 1Ch), and magnetic flux path connection regions (1Ea, 1Eb, 1Ec, 1Ed, 1Ee, 1Ef). The first magnetic conductor 1D comprises magnetic field input regions (1Axa, 1Axb) shared with the second magnetic conductor 2D.

Here, the first magnetic conductor 1D and the second magnetic conductor 2D may be made of soft magnetic metal materials, the XY direction conversion regions 1Ca and 1Cg are corners pointing to the negative X-axis direction and the negative Y-axis direction, the XY direction conversion regions 1Cb and 1Ch are corners pointing to the positive X-axis direction and the positive Y-axis direction, the XY direction conversion regions 1Cc and 1Ce are corners pointing to the negative X-axis direction and the positive Y-axis direction, and the XY direction conversion regions 1Cd and 1Cf are corners pointing to the positive X-axis direction and the negative Y-axis direction. The magnetic flux path connection region 1Ea connects to the XY direction conversion regions 1Ca and 1Cb in the Y-axis direction; the magnetic flux path connection region 1Eb connects to the XY direction conversion regions 1Cb and 1Cc in the X-axis direction, the magnetic flux path connection region 1Ec connects to the XY direction conversion regions 1Cc and 1Cd in the Y-axis direction, the magnetic flux path connection region 1Ed connects to the XY direction conversion regions 1Ce and 1Cf in the Y-axis direction, the magnetic flux path connection region 1Ee connects to the XY direction conversion regions 1Cf and 1Cg in the X-axis direction, and the magnetic flux path connection region 1Ef connects to the XY direction conversion regions 1Cg and 1Ch in the Y-axis direction. Furthermore, the magnetic flux path connection regions 1Ea, 1Ec, 1Ed, 1Ef and the first magnetic conductor 1D are each provided with two air gaps that penetrate the soft magnetic metal material along the X-axis direction.

Specifically, the description is provided assuming that the external magnetic field is in the positive X-axis direction. At this moment, the soft magnetic metal material concentrates and amplifies the external magnetic field and forms two magnetic flux paths that are mirror-symmetric with respect to the X-axis and connected in parallel. The two magnetic circuits pass through the magnetic field input regions 1Axa and 1Axb, respectively, and then enter the XY direction conversion regions 1Ca and 1Ce along the positive X-axis direction, respectively. Subsequently, the XY direction conversion regions 1Ca and 1Ce twist the magnetic circuits to the negative Y-axis direction and the positive Y-axis direction on two sides. One of the magnetic circuits passes through the magnetic flux path connection region 1Ea with an air gap along the negative Y-axis direction, and a magnetic field component in the negative Y-axis direction is generated in the air gap; the magnetic circuit then passes through the XY direction conversion region 1Cb, the magnetic flux path connection region 1Eb, and the XY direction conversion region 1Cc in sequence, and after twisting the magnetic circuit from the negative Y-axis direction and reversing it to the positive Y-axis direction, it then passes through the magnetic flux path connection region 1Ec with an air gap, and a magnetic field component in the positive Y-axis direction is generated in the air gap. The other magnetic circuit passes through the magnetic flux path connection region 1Ed with an air gap along the positive Y-axis direction, and a magnetic field component in the positive Y-axis direction is generated in the air gap; the magnetic circuit then passes through the XY direction conversion region 1Cf, the magnetic flux path connection region 1Ee, and the XY direction conversion region 1Cg in sequence, and after twisting the magnetic circuit from the positive Y-axis direction and reversing it to the negative Y-axis direction, it then passes through the magnetic flux path connection region 1Ef with an air gap, and a magnetic field component in the negative Y-axis direction is generated in the air gap. As a result, a magnetic field to be measured in the X-axis direction can be made to generate opposite magnetic field components in the positive and negative Y-axis directions in air gaps at different locations, thereby forming a differential magnetic field; finally, the two magnetic circuits in the positive and negative Y-axis directions are twisted back to the positive X-axis direction by the XY direction conversion regions 1Cd and 1Ch, and then arrive at the external magnetic field through the magnetic field input regions 1Bxa and 1Bxb.

When the direction of the external magnetic field is the negative X-axis direction, it will enter the magnetic field input regions 1Bxa and 1Bxb, pass through the XY direction conversion regions (1Ca, 1Cb, 1Cc, 1Cd, 1Ce, 1Cf, 1Cg, 1Ch) and the magnetic flux path connection regions (1Ea, 1Eb, 1Ec, 1Ed, 1Ee, 1Ef) to the magnetic field input region 1Ax, and return to the external magnetic field from the magnetic field input regions 1Axa and 1Axb. Specifically, opposite magnetic field components in the positive and negative Y-axis directions are generated through the conversion magnetic circuit in second air gaps at different locations, thereby forming a differential magnetic field.

Specifically, for the X-axis magnetic field measurement region 4x with the magnetic field induction direction being the X-axis direction, the second magnetic induction unit comprises a magnetic induction unit 2Xa, a magnetic induction unit 2Xb, a magnetic induction unit 2Xc, and a magnetic induction unit 2Xd. Taking the sensitivity directions of all the second magnetic induction units being the positive Y-axis direction and the external magnetic field being in the positive X-axis direction as an example, a magnetic field component in the negative Y-axis direction is generated in the air gaps of the magnetic flux path connection regions 1Ea and 1Ef, and a magnetic field component in the positive Y-axis direction is generated in the air gaps of the magnetic flux path connection regions 1Ec and 1Ed. Since the sensitivity directions of the magnetic induction units 2Xa, 2Xb, 2Xc, and 2Xd are all in the positive Y-axis direction, the resistance values of the magnetic induction units 2Xa and 2Xd increase, while the resistance values of the magnetic induction units 2Xb and 2Xc decrease. Therefore, the magnetic induction units 2Xa, 2Xb, 2Xc, and 2Xd can be connected in series or parallel to form a push-pull half-bridge or push-pull full-bridge structure to sense a magnetic field in the positive X-axis direction and generate a differential voltage signal; alternatively, the magnetic induction units 2Xa, 2Xb, 2Xc, and 2Xd can be selected to form, together with a reference resistor with a fixed resistance value, a differential half-bridge or differential full-bridge structure to sense a magnetic field in the positive X-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the second magnetic signal output circuit for detecting the second direction (i.e., the X-axis direction); or a closed-loop magnetic field feedback structure can be constructed by using a closed-loop signal conditioning circuit, a magnetic field feedback coil, and a magnetic induction unit (the magnetic induction units 2Xa, 2Xb, 2Xc, and 2Xd); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the second magnetic signal output circuit for detecting the second direction (i.e., the X-axis direction).

FIG. 8 is a simulation diagram of a fifth type of magnetic flux path according to the embodiments of the present application. Specifically, FIG. 8 is a simulation diagram of the magnetic flux path after applying a magnetic field to be measured in the positive X-axis direction to the X-axis magnetic field measurement region 4x in the embodiment provided in FIG. 7; and it can be seen that the magnetic field to be measured is concentrated and amplified by the soft magnetic metal material to form two magnetic flux paths that are mirror-symmetric with respect to the X-axis and connected in parallel. At the air gaps of the magnetic flux path connection regions 1Ea, 1Ec, 1Ed, and 1Ef, distinct opposite magnetic field components in the positive and negative Y-axis directions can be generated to form a differential magnetic field, and the magnetic circuit substantially does not pass through the first magnetic conductor 1D and the first magnetic flux divider 1F. Therefore, the influence of the external magnetic field in the X-axis direction on the Y-axis measurement can be ignored.

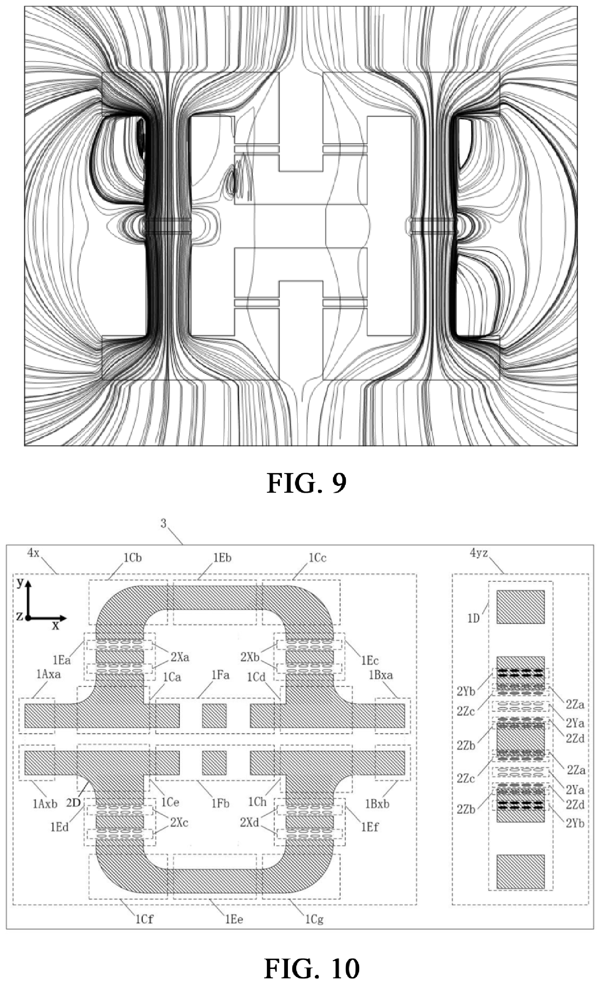

FIG. 9 is a simulation diagram of a sixth type of magnetic flux path according to the embodiments of the present application. Specifically, FIG. 9 is a simulation diagram of the magnetic flux path after applying a magnetic field to be measured in the positive Y-axis direction to the Y-axis magnetic field measurement region 4y in the embodiment provided in FIG. 7. The magnetic circuit that has been concentrated and amplified passes equally through the first magnetic conductor 1D and the first magnetic flux divider 1F provided with air gaps along the positive Y-axis direction, and generates a magnetic field component in the positive Y-axis direction in the air gaps. Since the sensitivity directions of the first magnetic induction unit 2Ya and the first magnetic shielding magnetic induction unit 2Yb are both in the positive Y-axis direction, the resistance value of the first magnetic induction unit 2Ya decreases, while as the first magnetic shielding magnetic induction unit 2Yb detects the magnetic field weakened by the shielding of the soft magnetic metal material, the resistance value can be considered to be approximately unchanged. Therefore, a differential half-bridge or differential full-bridge structure can be used to sense the magnetic field in the positive Y-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the first magnetic signal output circuit for detecting the first direction (i.e., the Y-axis direction); or a closed-loop magnetic field feedback structure can be constructed by using a closed-loop signal conditioning circuit, a magnetic field feedback coil, and a magnetic induction unit (the first magnetic induction unit 2Ya and the first magnetic shielding magnetic induction unit 2Yb); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the first magnetic signal output circuit for detecting the first direction (i.e., the Y-axis direction).

As can be seen from the above analysis of FIG. 9, the magnetic fields generated by the magnetic circuit, which is generated by the external magnetic field in the Y-axis direction, at the air gaps of the magnetic flux path connection regions 1Ea, 1Ec, 1Ed, and 1Ef used for X-axis measurement are extremely small and all in the positive Y-axis direction. Therefore, when the magnetic flux path connection regions 1Ea, 1Ec, 1Ed, and 1Ef form a push-pull half-bridge or push-pull full-bridge structure, the external magnetic field in the Y-axis direction will basically not affect the differential voltage signal generated by the bridge, thereby leading to the characteristics of strong anti-interference capability.

FIG. 10 is a structural schematic diagram of a projection of a fourth type of multi-axis magnetic field sensor on a plane according to the embodiments of the present application.

In some optional embodiments, the second magnetic conductor 2D further comprises: magnetic flux dividing circuits (1Fa, 1Fb) connecting the magnetic field input regions (1Axa, 1Axb, 1Bxa, 1Bxb) at two ends of the second magnetic conductor 2D; the magnetic flux dividing circuit (1Fa, 1Fb) has a second magnetic flux dividing air gap in the second direction; and the sensor adjusts the measurement sensitivity for the magnetic flux intensity in the second direction by adjusting the width of the second magnetic flux dividing air gap.

In some optional embodiments, the distances from the first magnetic induction unit 1Ya to the first magnetic conductor 1D and to the second magnetic conductor 2D are both greater than a first preset distance; the sensor further comprises: a third magnetic induction unit 2Z (2Za, 2Zb, 2Zc, 2Zd); wherein the projection of the third magnetic induction unit 2Z on the plane is located within the magnetic flux guiding region of the first magnetic conductor 1D and adjacent to the first air gap region, or the projection on the plane is located within the first air gap region and adjacent to the magnetic flux guiding region of the first magnetic conductor 1D, or the projection on the plane is located within the magnetic flux guiding region of the second magnetic conductor 2D and adjacent to the second air gap region, or the projection on the plane is located within the second air gap region and adjacent to the magnetic flux guiding region of the second magnetic conductor 2D; and the magnetic induction sensitivity direction of the third magnetic induction unit 2Z is the same as the magnetic induction sensitivity direction of the first magnetic induction unit 2Ya or the second magnetic induction unit 2X; wherein the distance from the third magnetic induction unit 2Z to the first magnetic conductor 1D or to the second magnetic conductor 2D is less than a second preset distance; the second preset distance is less than the first preset distance; and the sensor forms a third magnetic signal output circuit based on the third magnetic induction unit 2Z for measuring the magnetic flux intensity in a third direction; wherein the third direction is perpendicular to the plane (the substrate 3).

Here, the distances from the first magnetic shielding magnetic induction unit 2Yb to the first magnetic conductor 1D and to the second magnetic conductor 2D are both greater than the first preset distance. Specifically, when the projection of the third magnetic induction unit 2Z on the plane is located within the magnetic flux guiding region of the first magnetic conductor 1D and adjacent to the first air gap region, or when the projection on the plane is located within the first air gap region and adjacent to the magnetic flux guiding region of the first magnetic conductor 1D, the distance between the third magnetic induction unit 2Z and the first magnetic conductor 1D is less than the second preset distance. When the projection of the third magnetic induction unit 2Z on the plane is located within the magnetic flux guiding region of the second magnetic conductor 2D and adjacent to the second air gap region, or when the projection on the plane is located within the second air gap region and adjacent to the magnetic flux guiding region of the second magnetic conductor 2D, the distance between the third magnetic induction unit 2Z and the second magnetic conductor 2D is less than the second preset distance.

Here, as shown in FIG. 10, the second magnetic conductor 2D comprises magnetic field input regions (1Axa, 1Axb, 1Bxa, 1Bxb), XY direction conversion regions (1Ca, 1Cb, 1Cc, 1Cd, 1Ce, 1Cf, 1Cg, 1Ch), magnetic flux path connection regions (1Ea, 1Eb, 1Ec, 1Ed, 1Ee, 1Ef), and magnetic flux dividing circuit (1Fa, 1Fb). The first magnetic conductor 1D comprises magnetic field input regions (1Axa, 1Axb) shared with the second magnetic conductor 2D. The first magnetic conductor 1D and the second magnetic conductor 2D may be made of soft magnetic metal materials, the XY direction conversion region 1Ca comprises three ports pointing to the positive X-axis direction, the negative X-axis direction, and the positive Y-axis direction and is connected with the magnetic field input region 1Axa, the XY direction conversion region 1Cb is a corner pointing to the positive X-axis direction and the negative Y-axis direction, the XY direction conversion region 1Cc is a corner pointing to the negative X-axis direction and the negative Y-axis direction, the XY direction conversion region 1Cd comprises three ports pointing to the positive X-axis direction, the negative X-axis direction, and the positive Y-axis direction and is connected with the magnetic field input region 1Bxa, the XY direction conversion region 1Ce comprises three ports pointing to the positive X-axis direction, the negative X-axis direction, and the negative Y-axis direction and is connected with the magnetic field input region 1Axb, the XY direction conversion region 1Cf is a corner pointing to the positive X-axis direction and the positive Y-axis direction, the XY direction conversion region 1Cg is a corner pointing to the negative X-axis direction and the positive Y-axis direction, and the XY direction conversion region 1Ch comprises three ports pointing to the positive X-axis direction, the negative X-axis direction, and the negative Y-axis direction and is connected with the magnetic field input region 1Bxb. The magnetic flux path connection region 1Ea connects to the XY direction conversion regions 1Ca and 1Cb in the Y-axis direction; the magnetic flux path connection region 1Eb connects to the XY direction conversion regions 1Cb and 1Cc in the X-axis direction, the magnetic flux path connection region 1Ec connects to the XY direction conversion regions 1Cc and 1Cd in the Y-axis direction, the magnetic flux path connection region 1Ed connects to the XY direction conversion regions 1Ce and 1Cf in the Y-axis direction, the magnetic flux path connection region 1Ee connects to the XY direction conversion regions 1Cf and 1Cg in the X-axis direction, and the magnetic flux path connection region 1Ef connects to the XY direction conversion regions 1Cg and 1Ch in the Y-axis direction. Furthermore, the magnetic flux path connection regions 1Ea, 1Ec, 1Ed, 1Ef are each provided with two air gaps that penetrate the soft magnetic metal material along the X-axis direction.

In this embodiment, the magnetic flux dividing circuits (1Fa, 1Fb) perform magnetic flux division on the magnetic circuit of the input magnetic field to be measured on the X-axis. The magnetic flux dividing circuits (1Fa, 1Fb) perform magnetic flux division on the magnetic circuit of the input magnetic field to be measured on the X-axis, thereby regulating the magnitude of the magnetic field at the air gaps of the magnetic flux path connection regions 1Ea, 1Ec, 1Ed, and 1Ef. When the magnetic flux dividing circuits (1Fa, 1Fb) do not contain an air gap, the magnetic circuit will mostly pass through the magnetic flux dividing circuits (1Fa, 1Fb), but when the magnetic flux dividing circuits (1Fa, 1Fb) contain air gaps, the magnetic flux division ratio can be controlled by adjusting the number and width of the air gaps, thereby adjusting the overall sensitivity of the multi-axis magnetic field sensor.

Specifically, the description is provided assuming that the external magnetic field is in the positive X-axis direction. At this moment, a magnetic field component in the positive Y-axis direction is generated in the air gaps of the magnetic flux path connection regions 1Ea and 1Ef, and a magnetic field component in the negative Y-axis direction is generated in the air gaps of the magnetic flux path connection regions 1Ec and 1Ed. Since the sensitivity directions of the second magnetic induction units 2Xa, 2Xb, 2Xc, and 2Xd are all in the positive Y-axis direction, the resistance values of the second magnetic induction units 2Xa and 2Xd decrease, while the resistance values of the second magnetic induction units 2Xb and 2Xc increase. Therefore, the second magnetic induction units 2Xa, 2Xb, 2Xc, and 2Xd can be connected in series or parallel to form a push-pull half-bridge or push-pull full-bridge structure to sense a magnetic field in the positive X-axis direction and generate a differential voltage signal; alternatively, the second magnetic induction units 2Xa, 2Xb, 2Xc, and 2Xd can be selected to form, together with a reference resistor with a fixed resistance value, a differential half-bridge or differential full-bridge structure to sense a magnetic field in the positive X-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the second magnetic signal output circuit for detecting the second direction (i.e., the X-axis direction); or a closed-loop magnetic field feedback structure can be constructed by using a closed-loop signal conditioning circuit, a magnetic field feedback coil, and a magnetic induction unit (the magnetic induction units 2Xa, 2Xb, 2Xc, and 2Xd); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the second magnetic signal output circuit for detecting the second direction (i.e., the X-axis direction).

Among them, the first magnetic induction unit 2Ya and the first magnetic shielding magnetic induction unit 2Yb are used to measure a magnetic field to be measured in the Y-axis direction. Taking the external magnetic field being in the positive Y-axis direction as an example, the magnetic circuit that has been concentrated and amplified passes through the first magnetic conductor 1D with an air gap along the positive Y-axis direction, and generates a magnetic field component in the positive Y-axis direction in the first air gap. Since the sensitivity directions of the first magnetic induction unit 2Ya and the first magnetic shielding magnetic induction unit 2Yb are both in the positive Y-axis direction, the resistance value of the first magnetic induction unit 2Ya decreases, while as the first magnetic shielding magnetic induction unit 2Yb detects the magnetic field weakened by the shielding of the soft magnetic metal material, the resistance value can be considered to be approximately unchanged. Therefore, a differential half-bridge or differential full-bridge structure can be used to sense the magnetic field in the positive Y-axis direction and generate a differential voltage signal.

Among them, the third magnetic induction units 2Za, 2Zb, 2Zc, and 2Zd are used to measure a magnetic field to be measured in the Z-axis direction. Taking the external magnetic field being in the positive Z-axis direction as an example, due to the magnetic flux concentration effect of the soft magnetic metal material, a magnetic field will be distorted at the edge of the soft magnetic metal material when entering and exiting the soft magnetic metal material. A magnetic field component in the negative Y-axis direction is generated at the third magnetic induction units 2Za and 2Zc, and thus the resistance value increases. A magnetic field component in the positive Y-axis direction is generated at the third magnetic induction units 2Zb and 2Zd, and thus the resistance value decreases. Moreover, the degree of magnetic field distortion at the third magnetic induction units 2Zc and 2Zd is greater than the degree of magnetic field distortion at the third magnetic induction units 2Za and 2Zb. Therefore, depending on the requirements, the third magnetic induction units 2Za and 2Zb can be selected to form a push-pull half-bridge or push-pull full-bridge structure, or the third magnetic induction units 2Zc and 2Zd can be selected to form a push-pull half-bridge or push-pull full-bridge structure, to sense a magnetic field in the positive Z-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the second magnetic signal output circuit for detecting the third direction (i.e., the Z-axis direction); or a closed-loop magnetic field feedback structure can be constructed by using a closed-loop signal conditioning circuit, a magnetic field feedback coil, and a magnetic induction unit (the third magnetic induction units 2Za, 2Zb, 2Zc, and 2Zd); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the third magnetic signal output circuit for detecting the third direction (i.e., the Z-axis direction).

Specifically, the magnetic field induction direction of the Y-axis and Z-axis magnetic field measurement region 4yz is the Y-axis and Z-axis directions. In this embodiment, the Y-axis and Z-axis magnetic field measurement region 4yz comprises independently placed first magnetic conductors 1D, and the first magnetic conductors 1D are provided with a first air gap that penetrates the soft magnetic metal material along the X-axis direction. Alternatively, the first magnetic conductors 1D can also be regarded as a soft magnetic array distributed at certain intervals. When the external magnetic field is in the positive Y-axis direction, the operating principle of the Y-axis and Z-axis magnetic field measurement region 4yz is substantially the same as that of the Y-axis magnetic field measurement region 4y in the corresponding embodiment of FIG. 1, where the magnetic circuit that has been concentrated and amplified passes through the first magnetic conductor 1D with a first air gap along the positive Y-axis direction, and generates a magnetic field component in the positive Y-axis direction in the first air gap. When the external magnetic field is in the positive Z-axis direction, the Y-axis and Z-axis magnetic field measurement region 4yz can be regarded as a soft magnetic array distributed at certain intervals. Due to the magnetic flux concentration effect of the soft magnetic metal material, a magnetic field will be distorted at the edge of the soft magnetic metal material when entering and exiting the soft magnetic metal material, that is, a magnetic field to be measured in the Z-axis direction will generate a magnetic field component in the X-axis and Y-axis directions. When a magnetic field enters one end of the soft magnetic metal material, the magnetic field component tends to point towards the interior of the soft magnetic metal material; when a magnetic field leaves one end of the soft magnetic metal material, the magnetic field component tends to point towards the exterior of the soft magnetic metal material.

In industrial production, the actual thickness of a soft magnetic metal material is much greater than the actual thickness of a magnetic induction unit, and the magnetic induction unit is usually located near the upper plane (the side of the positive Z-axis direction) or lower plane (e side of the negative Z-axis direction) of the soft magnetic metal material. Assuming that the plane where the magnetic induction unit is located is near the upper plane (the side of the positive Z-axis direction) of the soft magnetic metal material, all the magnetic induction units in FIG. 10 are located above the soft magnetic metal material (the side of the positive Z-axis direction). For the third magnetic induction unit 2Z used for Z-axis measurement, it is located in the vertical projection coverage region of the soft magnetic array within the Y-axis Z-axis magnetic field measurement region 4yz. As shown in FIG. 10, the third magnetic induction unit 2Za is located near the negative Y-axis edge of the soft magnetic metal material, and the third magnetic induction unit 2Zb is located near the positive Y-axis edge of the soft magnetic metal material. The third magnetic induction units 2Zc and 2Zd are located at the air gaps of the soft magnetic array within the Y-axis Z-axis magnetic field measurement region 4yz. As shown in FIG. 10, the third magnetic induction unit 2Zc is located near the negative Y-axis edge of the soft magnetic material, and the third magnetic induction unit 2Zd is located near the positive Y-axis edge of the soft magnetic material. It should be noted that, compared with the third magnetic induction units 2Za, 2Zb, 2Zc, and 2Zd, the first magnetic induction unit 2Ya and the first magnetic shielding magnetic induction unit 2Yb (which are farther from the soft magnetic metal material than the first preset distance) are farther from the Y-axis edge of the soft magnetic material. Therefore, the concentration and distortion of the magnetic circuit caused by the magnetic field to be measured in the Z-axis direction have virtually no effect on the first magnetic induction unit 2Ya and the first magnetic shielding magnetic induction unit 2Yb. Similarly, the magnetic field to be measured in the Y-axis direction produces approximately the same magnetic field in the Y-axis direction at the third magnetic induction units 2Za and 2Zb, and also produces approximately the same magnetic field in the Y-axis direction at the third magnetic induction units 2Zc and 2Zd. Therefore, no differential magnetic field will be generated that interferes with the Z-axis measurement.

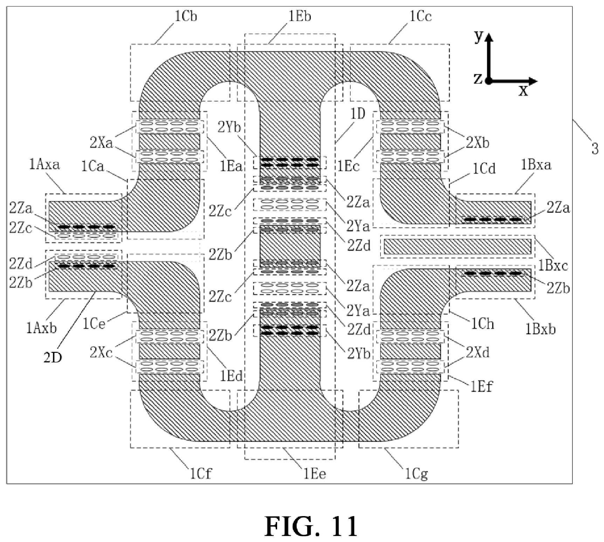

FIG. 11 is a structural schematic diagram of a projection of a fifth type of multi-axis magnetic field sensor on a plane according to the embodiments of the present application.

Here, as shown in FIG. 11, for the Z-axis measurement, due to the magnetic flux concentration effect of the soft magnetic metal material, a magnetic field will be distorted at the edge of the soft magnetic metal material when entering and exiting the soft magnetic metal material, that is, a magnetic field to be measured in the Z-axis direction will generate a magnetic field component in the X-axis and Y-axis directions. When a magnetic field enters one end of the soft magnetic metal material, the magnetic field component tends to point towards the interior of the soft magnetic metal material; when a magnetic field leaves one end of the soft magnetic metal material, the magnetic field component tends to point towards the exterior of the soft magnetic metal material. Therefore, the Z-axis measurement can be realized by using a soft magnetic array symmetrically distributed at a certain spacing. This embodiment provides three different Z-axis magnetic field measurement structures as Z-direction conversion regions. One type of the Z-direction conversion region structures is located in the Y-direction magnetic flux guiding region 1D in the middle of FIG. 11, and its Z-axis measurement principle is substantially the same as the Z-axis magnetic flux intensity measurement principle of the embodiment corresponding to FIG. 10, and is equivalent to merging the soft magnetic metal material of the Y-axis Z-axis magnetic field measurement region 4yz with the soft magnetic metal material of the X-axis magnetic field measurement region 4x; this embodiment is equivalent to using a soft magnetic array with two gaps that are symmetrically distributed about the X-axis, and in practical applications, the number of gaps and the shape of the soft magnetic material can be adjusted as needed to achieve Z-axis measurement without affecting Y-axis measurement. Another Z-direction conversion region structure is located on the left side of FIG. 11, which shares the soft magnetic metal material with the magnetic field input regions (1Axa, 1Axb). The last type of Z-direction conversion region structure is located on the right side of FIG. 11, which shares the soft magnetic metal material with the magnetic field output regions (1Bxa, 1Bxb, 1Bxc), and is equivalent to using a soft magnetic material with two gaps that are symmetrically distributed about the X-axis. In practical applications, the number of gaps and the shape of the soft magnetic material in the magnetic field input regions or magnetic field output regions can be adjusted as needed to achieve Z-axis measurement without affecting X-axis measurement.

Among them, one or more structures thereof located in the magnetic field input regions of the first magnetic conductor 1D or the second magnetic conductor can be selected to measure the Z-axis magnetic field according to actual needs. Furthermore, the magnetic field distortion at the third magnetic induction units 2Zc and 2Zd is greater than that at the third magnetic induction units 2Za and 2Zb. Depending on the requirements, the magnetic induction units 2Za and 2Zb can be selected to form a push-pull half-bridge or push-pull full-bridge structure, or the magnetic induction units 2Zc and 2Zd can be selected to form a push-pull half-bridge or push-pull full-bridge structure, to sense a magnetic field in the positive Z-axis direction and generate a differential voltage signal. In addition, an open-loop signal conditioning circuit can be further used to perform conditioning and amplification, temperature compensation, and/or linearity correction on the generated differential voltage signal, which is then used to form an output signal of the second magnetic signal output circuit for detecting the third direction (i.e., the Z-axis direction); or a closed-loop magnetic field feedback structure can be constructed by using a closed-loop signal conditioning circuit, a magnetic field feedback coil, and a magnetic induction unit (the magnetic induction units 2Za and 2Zb or the magnetic induction units 2Zc and 2Zd); after the generated differential voltage signal is amplified by the closed-loop signal conditioning circuit, a feedback magnetic field is generated through the magnetic field feedback coil to achieve dynamic magnetic field balance, and the feedback current of the magnetic field feedback coil is sampled to form an output signal of the third magnetic signal output circuit for detecting the third direction (i.e., the Z-axis direction).

In some optional embodiments, the sensor further comprises: an external magnetic field induction unit 2A; the magnetic induction sensitivity direction of the external magnetic field induction unit 2A is the same as the magnetic induction sensitivity direction of the first magnetic induction unit 2Ya or the second magnetic induction unit 2X, and the distances from the external magnetic field induction unit 2A to the first magnetic conductor 1D and to the second magnetic conductor 2D are both greater than a third preset distance; the sensor forms the first magnetic signal output circuit based on the external magnetic field induction unit 2A and the first magnetic induction unit 2Ya; and the sensor forms the second magnetic signal output circuit based on the external magnetic field induction unit 2A and the second magnetic induction unit 2X.

Here, as shown in FIG. 4, the multi-axis magnetic field sensor further comprises an external magnetic field induction unit 2A whose "projection on the substrate 3 is located outside the magnetic flux guiding regions of the first magnetic conductor and the second magnetic conductor," the external magnetic field induction unit 2A is located far from the soft magnetic metal material and is directly affected by the external magnetic field, and therefore, in cases of low-sensitivity and wide-range measurement, the first magnetic induction unit 2Ya at the first air gap can be selected to form a differential half-bridge or differential full-bridge structure with the external magnetic field induction unit 2A to sense the magnetic field in the Y-axis direction and generate a differential voltage signal. It is also feasible to select the second magnetic induction unit 2X at the second air gap to form a differential half-bridge or differential full-bridge structure with the external magnetic field induction unit 2A to sense the magnetic field in the X-axis direction and generate a differential voltage signal. It should be noted that when the distance between the external magnetic field induction unit 2A and the soft magnetic metal material is greater than the third preset distance, the external magnetic field induction unit 2A will be directly affected by the external magnetic field, and the third preset distance can be determined according to the actual magnetic induction range.

In some optional embodiments, the sensor further comprises: a resistor; the sensor forms the first magnetic signal output circuit based on the resistor and the first magnetic induction unit 1Ya; and the sensor forms the second magnetic signal output circuit based on the resistor and the second magnetic induction unit 2X.

Since all the magnetic induction units of the multi-axis magnetic field sensor provided in the embodiments of the present application have the same sensitivity direction, a magnetoresistive sensitive element, such as tunnel magnetoresistive (TMR), with a sensitivity direction parallel to its own plane, can be selected as the magnetic induction unit, which is combined with lead pads and mechanical support housing, and a single-chip integrated fabrication process is adopted.

The functional modules in the various embodiments of the present application can be integrated together to form one independent part, or each of the modules can exist independently, or two or more of the modules can be integrated to form one independent part.

The above description is only an optional implementation of the embodiments of the present application, but the protection scope of the embodiments of the present application is not limited thereto. Any changes or substitutions that can be easily conceived by those skilled in the art within the technical scope disclosed in the embodiments of the present application shall be encompassed within the protection scope of the embodiments of the present application.

## Claims

1. A multi-axis magnetic field sensor, **characterized in that** the sensor comprises:
a first magnetic conductor in a first direction, the first magnetic conductor having a first air gap in a second direction; wherein the first direction and the second direction are perpendicular to each other;
a second magnetic conductor located in the same plane as the first magnetic conductor, the second magnetic conductor comprising: magnetic field input regions located in the second direction and at two ends of the second magnetic conductor and magnetic field conversion regions located between the two ends of the second magnetic conductor, in which the magnetic field conversion regions comprise a conversion magnetic circuit in the first direction; wherein the conversion magnetic circuit has a second air gap in the second direction;
a first magnetic induction unit, a projection of the first magnetic induction unit on the plane being located in the first air gap region; the sensor forming, based on the first magnetic induction unit, a first magnetic signal output circuit for measuring the magnetic flux intensity in the first direction;
second magnetic induction units, the projections of the second magnetic induction units on the plane being located in the second air gap region; the sensor forming, based on the second magnetic induction units, a second magnetic signal output circuit for measuring the magnetic flux intensity in the second direction;
wherein the first magnetic induction unit and the second magnetic induction units have the same magnetic induction sensitivity direction, which is parallel to the first direction.

2. The sensor according to claim 1, **characterized in that** the conversion magnetic circuit comprises a first conversion magnetic circuit and a second conversion magnetic circuit that are adjacent to each other; the first conversion magnetic circuit has a first conversion air gap in the second direction, and the second conversion magnetic circuit has a second conversion air gap in the second direction;
the second magnetic induction unit comprises: a first conversion magnetic induction unit and a second conversion magnetic induction unit; the projection of the first conversion magnetic induction unit on the plane is located within the first conversion air gap region, and the projection of the second conversion magnetic induction unit on the plane is located within the second conversion air gap region;
and the sensor forms the second magnetic signal output circuit based on the first conversion magnetic induction unit and the second conversion magnetic induction unit.

3. The sensor according to claim 1, **characterized in that** the sensor further comprises: a first magnetic shielding magnetic induction unit; the projection of the first magnetic shielding magnetic induction unit on the plane is located within the magnetic flux guiding region of the first magnetic conductor; wherein the magnetic induction sensitivity direction of the first magnetic shielding magnetic induction unit is the same as the magnetic induction sensitivity direction of the first magnetic induction unit or the second magnetic induction unit;
and the sensor forms the first magnetic signal output circuit based on the first magnetic induction unit and the first magnetic shielding magnetic induction unit.

4. The sensor according to claim 1, **characterized in that** the sensor further comprises: a second magnetic shielding magnetic induction unit; the projection of the second magnetic shielding magnetic induction unit on the plane is located within the magnetic flux guiding region of the second magnetic conductor; wherein the magnetic induction sensitivity direction of the second magnetic shielding magnetic induction unit is the same as the magnetic induction sensitivity direction of the first magnetic induction unit or the second magnetic induction unit;
and the sensor forms the second magnetic signal output circuit based on the second magnetic induction unit and the second magnetic shielding magnetic induction unit.

5. The sensor according to claim 1, **characterized in that** the sensor further comprises: a first magnetic flux divider placed on the plane in the first direction; the first magnetic flux divider has a first magnetic flux dividing air gap in the second direction; and the sensor adjusts the measurement sensitivity for the magnetic flux intensity in the first direction by adjusting the width of the first magnetic flux dividing air gap and/or the number of the first magnetic flux dividing air gaps.

6. The sensor according to claim 1, **characterized in that** the second magnetic conductor further comprises: a magnetic flux dividing circuit connecting the magnetic field input regions at two ends of the second magnetic conductor; the magnetic flux dividing circuit has a second magnetic flux dividing air gap in the second direction; and the sensor adjusts the measurement sensitivity for the magnetic flux intensity in the second direction by adjusting the width of the second magnetic flux dividing air gap and/or the number of the second magnetic flux dividing air gaps.

7. The sensor according to claim 1, **characterized in that** the distances from the first magnetic induction unit to the first magnetic conductor and to the second magnetic conductor are both greater than a first preset distance;
the sensor further comprises: a third magnetic induction unit; wherein the projection of the third magnetic induction unit on the plane is located within the magnetic flux guiding region of the first magnetic conductor and adjacent to the first air gap region, or the projection on the plane is located within the first air gap region and adjacent to the magnetic flux guiding region of the first magnetic conductor, or the projection on the plane is located within the magnetic flux guiding region of the second magnetic conductor and adjacent to the second air gap region, or the projection on the plane is located within the second air gap region and adjacent to the magnetic flux guiding region of the second magnetic conductor; and the magnetic induction sensitivity direction of the third magnetic induction unit is the same as the magnetic induction sensitivity direction of the first magnetic induction unit or the second magnetic induction unit;
wherein the distance from the third magnetic induction unit to the first magnetic conductor or to the second magnetic conductor is less than a second preset distance; the second preset distance is less than the first preset distance; and the sensor forms a third magnetic signal output circuit based on the third magnetic induction unit for measuring the magnetic flux intensity in a third direction; wherein the third direction is perpendicular to the plane.

8. The sensor according to claim 1, **characterized in that** the sensor further comprises: an external magnetic field induction unit; the magnetic induction sensitivity direction of the external magnetic field induction unit is the same as the magnetic induction sensitivity direction of the first magnetic induction unit or the second magnetic induction unit, and the distances from the external magnetic field induction unit to the first magnetic conductor and to the second magnetic conductor are both greater than a third preset distance;
the sensor forms the first magnetic signal output circuit based on the external magnetic field induction unit and the first magnetic induction unit;
and the sensor forms the second magnetic signal output circuit based on the external magnetic field induction unit and the second magnetic induction unit.

9. The sensor according to claim 1, **characterized in that** the sensor further comprises: a resistor; the sensor forms the first magnetic signal output circuit based on the resistor and the first magnetic induction unit;
and the sensor forms the second magnetic signal output circuit based on the resistor and the second magnetic induction unit.

10. The sensor according to any one of claims 1-9, **characterized in that** the sensor further comprises: an open-loop signal conditioning circuit; the open-loop signal conditioning circuit is electrically connected to the first magnetic signal output circuit and the second magnetic signal output circuit respectively; the sensor performs conditioning and amplification, temperature compensation, and/or linearity correction on electrical signals output by the first magnetic signal output circuit and the second magnetic signal output circuit based on the open-loop signal conditioning circuit to obtain a first conditioning signal, and outputs the first conditioning signal; alternatively,
the sensor further comprises: a closed-loop signal conditioning circuit and a magnetic field feedback coil; the sensor forms a closed-loop magnetic field feedback structure based on the closed-loop signal conditioning circuit, the magnetic field feedback coil, and the magnetic induction units; the sensor performs conditioning and amplification, temperature compensation, and/or linearity correction on electrical signals output by the first magnetic signal output circuit and the second magnetic signal output circuit based on the closed-loop magnetic field feedback structure, generates a feedback magnetic field to achieve dynamic magnetic field balance and obtain a second conditioning signal, and outputs the second conditioning signal; wherein the second conditioning signal represents a feedback current of the magnetic field feedback coil reaching a state of dynamic magnetic field balance.
